# EUROPÄISCHE PATENTSCHRIFT

(11) **EP 3 507 895 B1**
(45) Veröffentlichungstag und Bekanntmachung des Hinweises auf die Patenterteilung: **12.08.2020**
(21) Anmeldenummer: 17791617.8
(22) Anmeldetag: 16.10.2017
(51) Int. Cl.: H02M 1/38, H03K 17/06

(54) **ÄNDERN EINES SCHALTZUSTANDS EINER SCHALT-HALBBRÜCKE**
CHANGE IN THE SWITCHING STATE OF A SWITCHING HALF BRIDGE
MODIFICATION D'UN ÉTAT DE COMMUTATION D'UN DEMI-PONT DE COMMUTATION

(30) Priorität: 27.10.2016 EP 16196035
(43) Veröffentlichungstag der Anmeldung: 10.07.2019
(73) Patentinhaber: Siemens Aktiengesellschaft, 80333 München (DE)
(72) Erfinder: MÄRZ, Andreas, 91227 Leinburg (DE); BAKRAN, Mark-Matthias, 91052 Erlangen (DE)
(86) Internationale Anmeldenummer: PCT/EP2017/076335
(87) Internationale Veröffentlichungsnummer: WO 2018/077650

(56) Entgegenhaltungen:
- WO-A1-2016/030954
- US-A1- 2007 115 705
- US-A1- 2007 195 563
- US-A1- 2008 265 975

## Beschreibung

Die Erfindung betrifft ein Verfahren und eine Schaltanordnung zum Ändern eines Schaltzustands einer Schalt-Halbbrücke, die zwei Feldeffekttransistoren aufweist, von einem ersten Schaltzustand, in dem ein erster Feldeffekttransistor eingeschaltet ist und der zweite Feldeffekttransistor abgeschaltet ist, zu einem zweiten Schaltzustand, in dem der erste Feldeffekttransistor abgeschaltet ist und der zweite Feldeffekttransistor eingeschaltet ist.

Insbesondere betrifft die Erfindung ein Verfahren und eine Schaltanordnung zum Ändern eines Schaltzustands einer Schalt-Halbbrücke, die zwei so genannte WBG-Feldeffekttransistoren aufweist (WBG = Wide-Bandgap). Unter einem WBG-Feldeffekttransistor wird ein Feldeffekttransistor verstanden, dessen Grundmaterial ein Halbleiter mit breitem Bandabstand (= Energieabstand zwischen Valenzband und Leitungsband) wie Siliziumkarbid oder Galliumnitrid ist. WBG-Feldeffekttransistoren eignen sich aufgrund ihrer geringeren Schaltverluste im Vergleich zu den häufig eingesetzten Bipolartransistoren mit isolierter Gate-Elektrode (IGBT) insbesondere vorteilhaft zur Verbesserung der Leistungsdichte von Stromrichtern wie Pulswechselrichtern oder Gleichspannungswandlern. Damit kann bei gleichen Schaltverlusten die Schaltfrequenz merklich erhöht werden, wodurch die Baugröße von passiven Komponenten im System wie von Filtern, Transformatoren und Zwischenkreiskondensatoren reduziert werden kann.

Bei hohen Schaltgeschwindigkeiten kann bei dem Abschalten eines Feldeffekttransistors einer Schalt-Halbbrücke der Effekt des parasitären Wiederaufsteuerns des Feldeffekttransistors auftreten. Dieser Effekt wird auch als parasitäres Wiedereinschalten oder "Selfturn-On" bezeichnet. Dabei wird die Gate-Source-Spannung zwischen Gate und Source des abschaltenden Feldeffekttransistors aufgrund eines kapazitiven Verschiebestroms kurzzeitig über die Schwellenspannung (Threshhold Voltage) des Feldeffekttransistors angehoben, wodurch der Feldeffekttransistor wieder leitend wird. Dies schlägt sich in stark erhöhten Abschaltverlusten des abschaltenden Feldeffekttransistors und Einschaltverlusten des einschaltenden komplementären Feldeffekttransistors der Schalt-Halbbrücke nieder.

US 2008/265975 A1 offenbart ein vorübergehendes Absenken einer Gate-Source-Spannung eines ersten Feldeffekttransistors von dem Einschaltniveau auf ein zweites Abschaltniveau, bevor ein zweiter Feldeffekttransistor eingeschaltet wird, und ein anschließendes Ändern der Gate-Source-Spannung des ersten Feldeffekttransistors auf ein erstes Abschaltniveau.

US 2007/115705 A1 offenbart Schaltanordnungen mit zwei Feldeffekttransistoren, deren Gate-Anschlüsse jeweils eine Zusatzschaltung mit einer Induktivität enthalten. Der Erfindung liegt die Aufgabe zugrunde, ein Verfahren und eine Schaltanordnung zum Ändern eines Schaltzustands einer Schalt-Halbbrücke, die zwei Feldeffekttransistoren aufweist, anzugeben, die insbesondere hinsichtlich des Vermeidens eines parasitäres Wiedereinschaltens beim Abschalten eines Feldeffekttransistors der Schalt-Halbbrücke verbessert sind.

Die Aufgabe wird erfindungsgemäß hinsichtlich des Verfahrens durch die Merkmale des Anspruchs 1 und hinsichtlich der Schaltanordnung durch die Merkmale des Anspruchs 5 gelöst. Vorteilhafte Ausgestaltungen der Erfindung sind Gegenstand der Unteransprüche.

Das erfindungsgemäße Verfahren sieht also vor, bei einem Wechsel des Schaltzustands der Schalt-Halbbrücke die Gate-Source-Spannung des abschaltenden (ersten) Feldeffekttransistors vorübergehend auf ein betragsmäßig erhöhtes (zweites) Abschaltniveau zu ändern und den anderen (zweiten) Feldeffekttransistor einzuschalten, während die Gate-Source-Spannung des abschaltenden Feldeffekttransistors dieses betragsmäßig erhöhte Abschaltniveau annimmt. Durch diese vorübergehende Änderung des Abschaltniveaus der Gate-Source-Spannung des ersten Feldeffekttransistors wird der Abstand des Abschaltniveaus von der Schwellenspannung des ersten Feldeffekttransistors kurzzeitig für die Zeitdauer des Kommutierungsvorgangs erhöht, wodurch ein parasitäres Wiedereinschalten des ersten Feldeffekttransistors vermieden wird. Dadurch wird vorteilhaft bei schnellem Schalten der Feldeffekttransistoren eine Erhöhung der Schaltverluste durch ein parasitäres Wiedereinschalten des jeweils abschaltenden Feldeffekttransistors vermieden.

Das erfindungsgemäße Verfahren sieht außerdem vor, die vorübergehende Erhöhung des Betrags des Abschaltniveaus des ersten Feldeffekttransistors durch eine zusätzliche Induktivität zu bewirken, die dem Gate-Anschluss des ersten Feldeffekttransistors vorgeschaltet wird. Diese Induktivität wirkt mit der Eingangskapazität des ersten Feldeffekttransistors, die die Summe der Kapazitäten zwischen Gate und Source und zwischen Gate und Drain des ersten Feldeffekttransistors ist, sowie einer parasitären Induktivität weiterer Komponenten der Schaltordnung als ein Reihenschwingkreis, der von einer Änderung der Steuerspannung des ersten Feldeffekttransistors angeregt wird und ein Überschwingen der Gate-Source-Spannung des ersten Feldeffekttransistors auf das zweite Abschaltniveau bewirkt. Dadurch braucht nicht die Steuerspannung des ersten Feldeffekttransistors vorübergehend auf das zweite Abschaltniveau geändert werden, um das Abschaltniveau des ersten Feldeffekttransistors zu ändern.

Eine Ausgestaltung des erfindungsgemäßen Verfahrens sieht vor, dass eine Zeitdauer vorgegeben wird, und dass die Gate-Source-Spannung des zweiten Feldeffekttransistors von dem ersten Abschaltniveau auf das Einschaltniveau zu einem Zeitpunkt geändert wird, der in einem durch die Zeitdauer definierten zeitlichen Abstand auf das Ändern der Steuerspannung des ersten Feldeffekttransistors von dem Einschaltniveau auf das erste Abschaltniveau folgt. Die Zeitdauer wird dabei derart vorgegeben, dass der zweite Feldeffekttransistor durch die Änderung seiner Gate-Source-Spannung dann eingeschaltet wird, wenn die Gate-Source-Spannung des ersten Feldeffekttransistors das zweite Abschaltniveau annimmt.

Die erfindungsgemäße Schaltanordnung ermöglicht die Realisierung des erfindungsgemäßen Verfahrens mit den oben bereits genannten Vorteilen.

Bei dem erfindungsgemäßen Verfahren und der erfindungsgemäßen Schaltanordnung kann jeder Feldeffekttransistor ein WBG-Feldeffekttransistor sein, d.h. jeder Feldeffekttransistor kann als Grundmaterial einen Halbleiter mit breitem Bandabstand, insbesondere Siliziumkarbid, aufweisen. Die Erfindung eignet sich besonders vorteilhaft für Schalt-Halbbrücken mit WBG-Feldeffekttransistoren, da diese hohe Schaltgeschwindigkeiten ermöglichen, bei denen ein parasitäres Wiedereinschalten des jeweils abschaltenden Feldeffekttransistors auftreten kann.

Ein erfindungsgemäßer Stromrichter weist wenigstens eine Schalt-Halbbrücke, die zwei Feldeffekttransistoren aufweist, und eine erfindungsgemäße Schaltanordnung zum Ändern eines Schaltzustands der Schalt-Halbbrücke auf. Die Vorteile eines derartigen Stromrichters ergeben sich aus den oben bereits genannten Vorteilen des erfindungsgemäßen Verfahrens bzw. der erfindungsgemäßen Schaltanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von einem Beispiel und einem Ausführungsbeispiel, die im Zusammenhang mit den Zeichnungen näher erläutert werden. Dabei zeigen:
- FIG 1: einen Schaltplan eines Stromrichters mit einer Schalt-Halbbrücke und einer Schaltanordnung zum Ändern eines Schaltzustands der Schalt-Halbbrücke,
- FIG 2: einen Teil-Schaltplan einer Schalt-Halbbrücke und eines Beispiels einer Schaltanordnung zum Ändern eines Schaltzustands der Schalt-Halbbrücke,
- FIG 3: zeitliche Verläufe von mit der in FIG 2 dargestellten Schaltanordnung erzeugten Steuerspannungen und Gate-Source-Spannungen der Feldeffekttransistoren einer Schalt-Halbbrücke,
- FIG 4: einen Teil-Schaltplan einer Schalt-Halbbrücke und eines Ausführungsbeispiels einer Schaltanordnung zum Ändern eines Schaltzustands der Schalt-Halbbrücke, und
- FIG 5: zeitliche Verläufe von mit der in FIG 4 dargestellten Schaltanordnung erzeugten Steuerspannungen und Gate-Source-Spannungen der Feldeffekttransistoren einer Schalt-Halbbrücke.

Einander entsprechende Teile sind in allen Figuren mit denselben Bezugszeichen versehen.

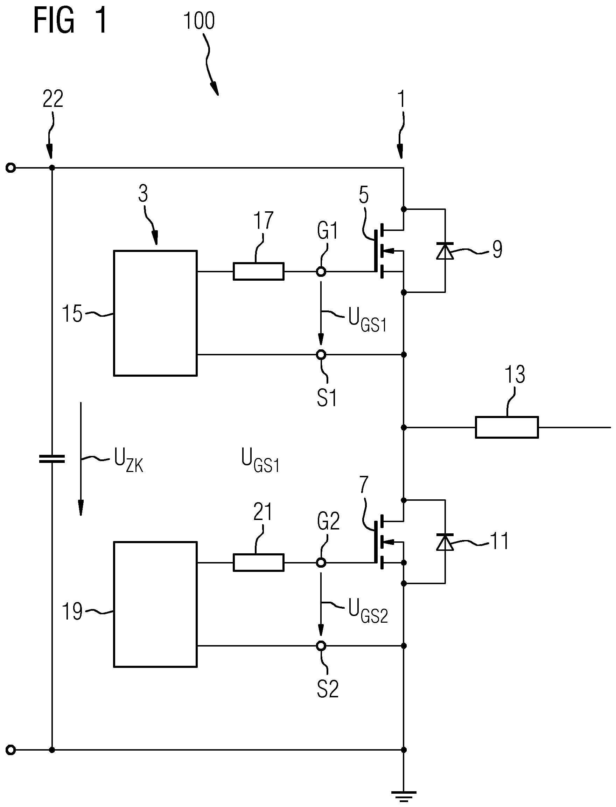

FIG 1 zeigt einen Schaltplan eines Stromrichters 100 mit einer Schalt-Halbbrücke 1 und einer Schaltanordnung 3 zum Ändern eines Schaltzustands der Schalt-Halbbrücke 1. Der Stromrichter 100 ist als ein einphasiger Pulswechselrichter ausgebildet.

Die Schalt-Halbbrücke 1 weist einen ersten Feldeffekttransistor 5 und einen zweiten Feldeffekttransistor 7, sowie optional eine zu dem ersten Feldeffekttransistor 5 antiparallel geschaltete erste Freilaufdiode 9 und eine zu dem zweiten Feldeffekttransistor 7 antiparallel geschaltete zweite Freilaufdiode 11 auf. Der Brückenzweig der Schalt-Halbbrücke 1 ist an eine Last 13 angeschlossen.

Die Feldeffekttransistoren 5, 7 sind beispielsweise selbstsperrende (normally-off) n-Kanal-Siliziumkarbid-Feldeffekttransistoren, d.h. selbstsperrende n-Kanal-Feldeffekttransistoren, deren Grundmaterial Siliziumkarbid ist und deren Schwellenspannung bei Raumtemperatur zwischen 1 V und 4 V liegt.

Die Schaltanordnung 3 weist einen ersten Gate-Treiber 15 und eine erste Zusatzschaltung 17 zum Ansteuern des ersten Feldeffekttransistors 5 und einen zweiten Gate-Treiber 19 und eine zweite Zusatzschaltung 21 zum Ansteuern des zweiten Feldeffekttransistors 7 auf.

Die Schalt-Halbbrücke 1 ist an einen Gleichspannungszwischenkreis 22 angeschlossen, so dass an der Schalt-Halbbrücke 1 eine Zwischenkreisspannung U_{ZK} des Gleichspannungszwischenkreises 22 anliegt.

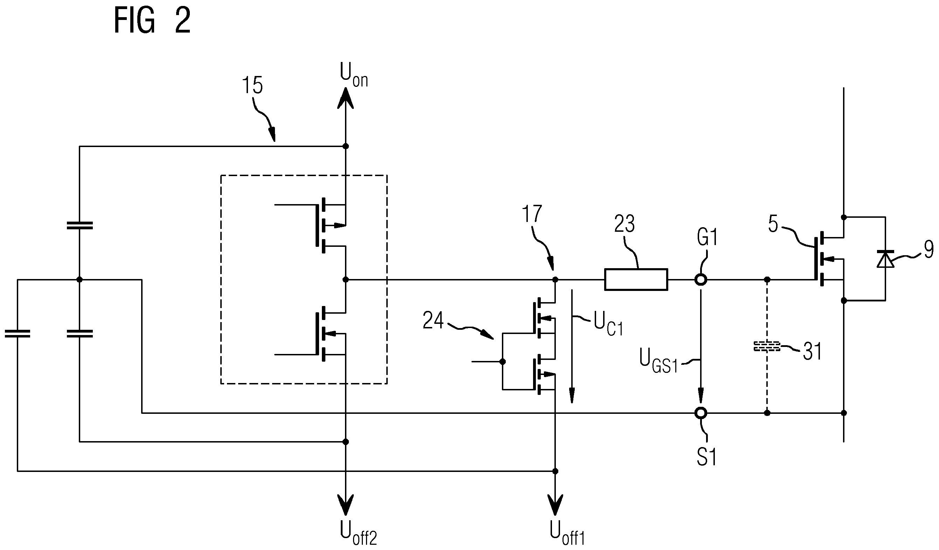

Ein Beispiel und ein Ausführungsbeispiel der Schaltanordnung 3 und deren Funktionsweise werden im Folgenden anhand der Figuren 2 bis 5 beschrieben.

FIG 2 zeigt ein Beispiel einer Schaltanordnung 3, wobei nur der erste Gate-Treiber 15 und die erste Zusatzschaltung 17 zum Ansteuern des ersten Feldeffekttransistors 5 der Schalt-Halbbrücke 1 dargestellt sind. Der zweite Gate-Treiber 19 und die zweite Zusatzschaltung 21 zum Ansteuern des zweiten Feldeffekttransistors 7 der Schalt-Halbbrücke 1 sind jeweils wie der erste Gate-Treiber 15 und die erste Zusatzschaltung 17 ausgebildet und geschaltet. Zwischen einen Gate-Anschluss G1, G2 des jeweiligen Feldeffekttransistors 5, 7 und den Gate-Treiber 15, 19 sowie die Zusatzschaltung 17, 21 des Feldeffekttransistors 5, 7 ist ein Vorwiderstand 23 geschaltet.

Jede Zusatzschaltung 17, 21 weist einen Zusatz-Gate-Treiber 24 zur Ansteuerung des jeweiligen Feldeffekttransistors 5, 7 auf. Der erste Gate-Treiber 15 und der Zusatz-Gate-Treiber 24 der ersten Zusatzschaltung 17 erzeugen eine erste Steuerspannung U_{C1}, mit der eine Gate-Source-Spannung U_{GS1} zwischen dem Gate-Anschluss G1 und einem Source-Anschluss S1 des ersten Feldeffekttransistors 5 gesteuert wird. Mit dem Zusatz-Gate-Treiber 24 der ersten Zusatzschaltung 17 ist die erste Steuerspannung U_{C1} auf ein erstes Abschaltniveau U_{off1} einstellbar. Mit dem ersten Gate-Treiber 15 ist die erste Steuerspannung U_{C1} auf ein Einschaltniveau Uₒₙ oder ein zweites Abschaltniveau U_{off2} einstellbar, wobei das zweite Abschaltniveau U_{off2} einen größeren Betrag als das erste Abschaltniveau U_{off1} hat. Für als selbstsperrende n-Kanal-Siliziumkarbid-Feldeffekttransistoren ausgebildete Feldeffekttransistoren 5, 7 liegen beispielsweise das erste Abschaltniveau U_{off1} zwischen -3 V und -5 V, das zweite Abschaltniveau U_{off2} zwischen -5 V und -10 V und das Einschaltniveau Uₒₙ zwischen 15 V und 20 V.

Entsprechend erzeugen der zweite Gate-Treiber 19 und die zweite Zusatzschaltung 21 eine zweite Steuerspannung U_{C2}, mit der eine Gate-Source-Spannung U_{GS2} zwischen dem Gate-Anschluss G2 und einem Source-Anschluss S2 des zweiten Feldeffekttransistors 7 gesteuert wird, wobei die zweite Steuerspannung U_{C2} mit der zweiten Zusatzschaltung 21 auf das erste Abschaltniveau U_{off1} und mit dem zweiten Gate-Treiber 19 auf das Einschaltniveau Uₒₙ oder das zweite Abschaltniveau U_{off2} einstellbar ist.

Das Einschaltniveau Uₒₙ ist ein Wert der Gate-Source-Spannungen U_{GS1}, U_{GS2}, bei dem der jeweilige Feldeffekttransistor 5, 7 eingeschaltet, d. h. leitend ist. Die Abschaltniveaus U_{off1}, U_{off2} sind Werte der Gate-Source-Spannungen U_{GS1}, U_{GS2}, bei denen der jeweilige Feldeffekttransistor 5, 7 abgeschaltet, d. h. nichtleitend ist.

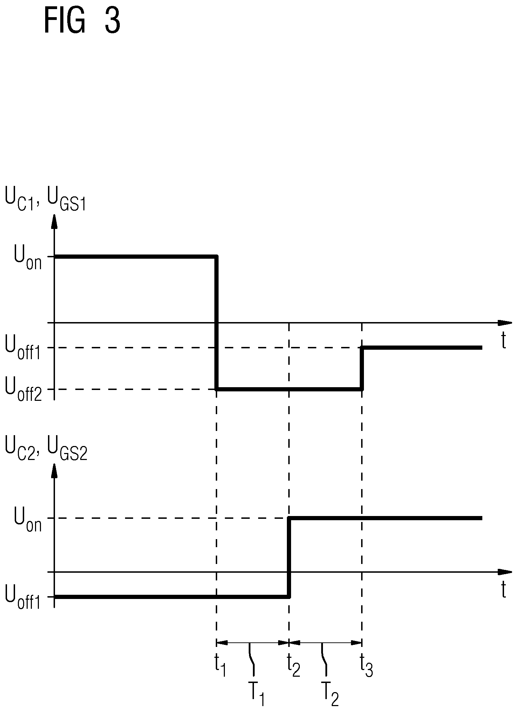

FIG 3 zeigt zeitliche Verläufe von mit der in FIG 2 dargestellten Schaltanordnung 3 erzeugten Steuerspannungen U_{C1}, U_{C2} und der dadurch erzeugten Gate-Source-Spannungen U_{GS1}, U_{GS2} der Feldeffekttransistoren 5, 7. Dargestellt sind die Verläufe der Steuerspannungen U_{C1}, U_{C2} und Gate-Source-Spannungen U_{GS1}, U_{GS2} in Abhängigkeit von einer Zeit t beim erfindungsgemäßen Ändern eines Schaltzustands der Schalt-Halbbrücke 1 von einem ersten Schaltzustand, in dem der erste Feldeffekttransistor 5 eingeschaltet ist und der zweite Feldeffekttransistor 7 abgeschaltet ist, zu einem zweiten Schaltzustand, in dem der erste Feldeffekttransistor 5 abgeschaltet ist und der zweite Feldeffekttransistor 7 eingeschaltet ist. In dem ersten ersten Schaltzustand nimmt die Gate-Source-Spannung U_{GS1} des ersten Feldeffekttransistors 5 das Einschaltniveau Uₒₙ an und die Gate-Source-Spannung U_{GS2} des zweiten Feldeffekttransistors 7 nimmt das erste Abschaltniveau U_{off1} an. In dem zweiten Schaltzustand nimmt die Gate-Source-Spannung U_{GS1} des ersten Feldeffekttransistors 5 das erste Abschaltniveau U_{off1} an und die Gate-Source-Spannung U_{GS2} des zweiten Feldeffekttransistors 7 nimmt das Einschaltniveau Uₒₙ an.

Ausgehend von dem ersten Schaltzustand wird zunächst zu einem ersten Zeitpunkt t₁ die erste Steuerspannung U_{C1} durch den ersten Gate-Treiber 15 von dem Einschaltniveau Uₒₙ zu dem zweiten Abschaltniveau U_{off2} geändert, wobei der Zusatz-Gate-Treiber 24 der ersten Zusatzschaltung 17 abgeschaltet bleibt. Dann wird zu einem zweiten Zeitpunkt t₂ durch den zweiten Gate-Treiber 19 die zweite Steuerspannung U_{C2} von dem ersten Abschaltniveau U_{off1} auf das Einschaltniveau Uₒₙ geändert, wobei der Zusatz-Gate-Treiber 24 der zweiten Zusatzschaltung 21 abgeschaltet wird. Danach wird zu einem dritten Zeitpunkt t₃ durch den Zusatz-Gate-Treiber 24 der ersten Zusatzschaltung 17 die erste Steuerspannung U_{C1} von dem zweiten Abschaltniveau U_{off2} auf das erste Abschaltniveau U_{off1} geändert, wobei der erste Gate-Treiber 15 abgeschaltet wird. Die Gate-Source-Spannung U_{GS1} des ersten Feldeffekttransistors 5 folgt dabei praktisch instantan der ersten Steuerspannung U_{C1}, so dass die Gate-Source-Spannung U_{GS1} des ersten Feldeffekttransistors 5 in FIG 3 mit der ersten Steuerspannung U_{C1} zusammenfällt. Entsprechend folgt die Gate-Source-Spannung U_{GS2} des zweiten Feldeffekttransistors 7 praktisch instantan der zweiten Steuerspannung U_{C2}, so dass die Gate-Source-Spannung U_{GS2} des zweiten Feldeffekttransistors 7 in FIG 3 mit der zweiten Steuerspannung U_{C2} zusammenfällt. Der zweite Zeitpunkt t₂ und der dritte Zeitpunkt t₃ werden dabei durch eine erste Zeitdauer T₁, die den zeitlichen Abstand zwischen t₁ und t₂ definiert, und eine zweite Zeitdauer T₂, die den zeitlichen Abstand zwischen t₂ und t₃ definiert, festgelegt, wobei die beiden Zeitdauern T₁, T₂ vorgegeben und fest eingestellt werden.

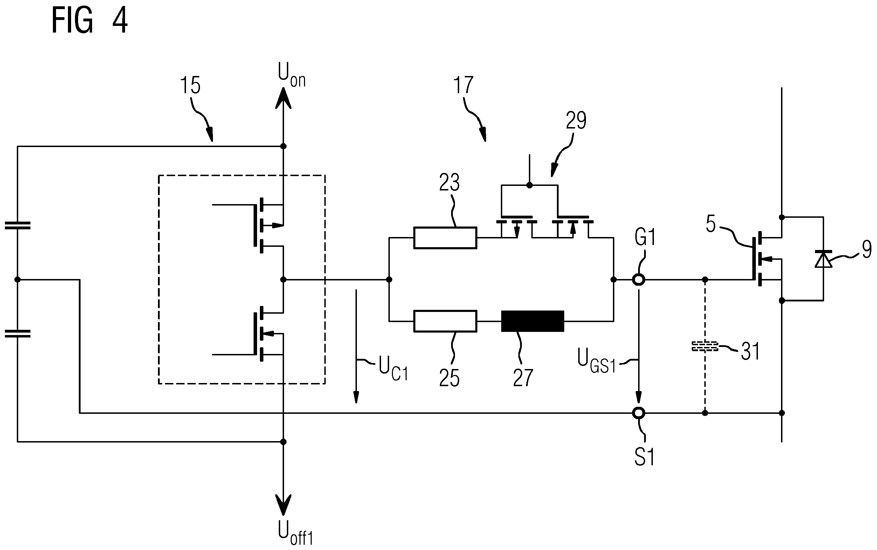

FIG 4 zeigt ein Ausführungsbeispiel einer Schaltanordnung 3, wobei wiederum nur der erste Gate-Treiber 15 und die erste Zusatzschaltung 17 zum Ansteuern des ersten Feldeffekttransistors 5 der Schalt-Halbbrücke 1 dargestellt sind. Der zweite Gate-Treiber 19 und die zweite Zusatzschaltung 21 zum Ansteuern des zweiten Feldeffekttransistors 7 der Schalt-Halbbrücke 1 sind jeweils wie der erste Gate-Treiber 15 und die erste Zusatzschaltung 17 ausgebildet und geschaltet.

Der erste Gate-Treiber 15 erzeugt eine erste Steuerspannung U_{C1} zur Steuerung der Gate-Source-Spannung U_{GS1} zwischen einem Gate-Anschluss G1 und einem Source-Anschluss S1 des ersten Feldeffekttransistors 5. Entsprechend erzeugt der zweite Gate-Treiber 19 eine zweite Steuerspannung U_{C2} zur Steuerung der Gate-Source-Spannung U_{GS2} zwischen einem Gate-Anschluss G2 und einem Source-Anschluss S2 des zweiten Feldeffekttransistors 7.

Jede Zusatzschaltung 17, 21 weist zwei zueinander parallel geschaltete Schaltungszweige auf, wobei ein erster Schaltungszweig einen Dämpfungswiderstand 25 und eine dazu in Reihe geschaltete Induktivität 27 aufweist und der zweite Schaltungszweig einen Vorwiderstand 23 und einen Hilfsschalter 29 aufweist.

Durch Öffnen des Hilfsschalters 29 kann der zweite Schaltungszweig unterbrochen werden, so dass nur der erste Schaltungszweig der Zusatzschaltung 17, 21 wirkt. Der erste Schaltungszweig bildet dann zusammen mit einer Eingangskapazität 31 des jeweiligen Feldeffekttransistors 5, 7, die die Summe der Kapazitäten zwischen Gate und Source und zwischen Gate und Drain des Feldeffekttransistors 5, 7 ist, und einer parasitären Induktivität weiterer Komponenten der Schaltanordnung 1 einen Reihenschwingkreis, der von Änderungen der jeweiligen Steuerspannung U_{C1}, U_{C2} angeregt wird.

Bei geschlossenem Hilfsschalter 29 wird die Wirkung des Reihenschwingkreises unterdrückt und die jeweilige Zusatzschaltung 17, 21 wirkt im Wesentlichen wie ein dem jeweiligen Gate-Anschluss G1, G2 vorgeschalteter ohmscher Widerstand.

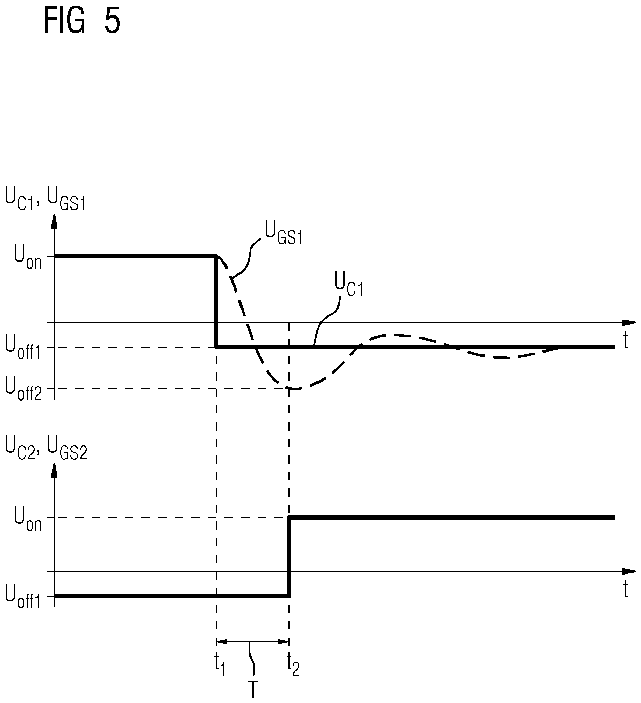

FIG 5 zeigt zeitliche Verläufe von mit der in FIG 4 dargestellten Schaltanordnung 3 erzeugten Steuerspannungen U_{C1}, U_{C2} und der dadurch erzeugten Gate-Source-Spannungen U_{GS1}, U_{GS2} der Feldeffekttransistoren 5, 7. Dargestellt sind die Verläufe der Steuerspannungen U_{C1}, U_{C2} und Gate-Source-Spannungen U_{GS1}, U_{GS2} in Abhängigkeit von einer Zeit t beim erfindungsgemäßen Ändern eines Schaltzustands der Schalt-Halbbrücke 1 von einem ersten Schaltzustand, in dem der erste Feldeffekttransistor 5 eingeschaltet ist und der zweite Feldeffekttransistor 7 abgeschaltet ist, zu einem zweiten Schaltzustand, in dem der erste Feldeffekttransistor 5 abgeschaltet ist und der zweite Feldeffekttransistor 7 eingeschaltet ist. In dem ersten Schaltzustand nimmt die Gate-Source-Spannung U_{GS1} des ersten Feldeffekttransistors 5 das Einschaltniveau Uₒₙ an und die Gate-Source-Spannung U_{GS2} des zweiten Feldeffekttransistors 7 nimmt das erste Abschaltniveau U_{off1} an. In dem zweiten Schaltzustand nimmt die Gate-Source-Spannung U_{GS1} des ersten Feldeffekttransistors 5 das erste Abschaltniveau U_{off1} an und die Gate-Source-Spannung U_{GS2} des zweiten Feldeffekttransistors 7 nimmt das Einschaltniveau Uₒₙ an.

Ausgehend von dem ersten Schaltzustand wird zunächst zu einem ersten Zeitpunkt t₁ die erste Steuerspannung U_{C1} durch den ersten Gate-Treiber 15 von dem Einschaltniveau Uₒₙ zu dem ersten Abschaltniveau U_{off1} geändert, wobei der Hilfsschalter 29 der ersten Zusatzschaltung 17 geöffnet ist, so dass die erste Zusatzschaltung 17, die Eingangskapazität 31 des ersten Feldeffekttransistors 5 und die parasitäre Induktivität weiterer Komponenten der Schaltanordnung 1 wie oben beschrieben einen Reihenschwingkreis bilden. Der Dämpfungswiderstand 25 und die Induktivität 27 der Zusatzschaltung 17 sind derart gewählt, dass die Änderung der ersten Steuerspannung U_{C1} von dem Einschaltniveau Uₒₙ zu dem ersten Abschaltniveau U_{off1} nach einer Zeitdauer T ein Überschwingen der Gate-Source-Spannung U_{GS1} des ersten Feldeffekttransistors 5 bis zu dem zweiten Abschaltniveau U_{off2} bewirkt und die Gate-Source-Spannung U_{GS1} des ersten Feldeffekttransistors 5 sich anschließend mit einer Dämpfung schnell auf das erste Abschaltniveau U_{off1} einschwingt. Zu einem zweiten Zeitpunkt t₂ wird durch den zweiten Gate-Treiber 19 die zweite Steuerspannung U_{C2} von dem ersten Abschaltniveau U_{off1} auf das Einschaltniveau Uₒₙ geändert, wobei der Hilfsschalter 29 der zweiten Zusatzschaltung 21 geschlossen ist, so dass die zweite Zusatzschaltung 21 im Wesentlichen als ein dem Gate-Anschluss G2 des zweiten Feldeffekttransistors 7 vorgeschalteter ohmscher Widerstand wirkt und die Gate-Source-Spannung U_{GS2} des zweiten Feldeffekttransistors 7 praktisch instantan der zweiten Steuerspannung U_{C2} folgt. Der zeitliche Abstand des zweiten Zeitpunkts t₂ von dem ersten Zeitpunkt t₁ wird dabei durch die Zeitdauer T definiert, die vorher bestimmt und fest eingestellt wird.

In beiden oben beschriebenen Beispiel und Ausführungsbeispiel wird also beim Abschalten des ersten Feldeffekttransistors 5 dessen Gate-Source-Spannung U_{GS1} zunächst auf das zweite Abschaltniveau U_{off2} abgesenkt, bevor der zweite Feldeffekttransistor 7 eingeschaltet wird und die Gate-Source-Spannung U_{GS1} des ersten Feldeffekttransistors 5 auf das erste Abschaltniveau U_{off1} eingestellt wird bzw. das erste Abschaltniveau U_{off1} erreicht. Durch diese vorübergehende Absenkung der Gate-Source-Spannung U_{GS1} wird vorteilhaft ein parasitäres Wiedereinschalten (Selfturn-On) des ersten Feldeffekttransistors 5 bei dessen schnellem Abschalten verhindert.

In beiden oben beschriebenen Beispiel und Ausführungsbeispiel wird beim Ändern des Schaltzustands der Schalt-Halbbrücke 1 von dem zweiten Schaltzustand zu dem ersten Schaltzustand analog zu dem beschriebenen Ändern des Schaltzustands von dem ersten Schaltzustand zu dem zweiten Schaltzustand verfahren, wobei lediglich die Gate-Treiber 15, 19 und Zusatzschaltungen 17, 21 ihre Rollen tauschen.

## Patentansprüche

1. Verfahren zum Ändern eines Schaltzustands einer Schalt-Halbbrücke (1), die einen ersten und einen zweiten Feldeffekttransistor (5, 7) aufweist, von einem ersten Schaltzustand, in dem eine Gate-Source-Spannung (U_{GS1}) des ersten Feldeffekttransistors (5) ein Einschaltniveau (Uₒₙ) annimmt und eine Gate-Source-Spannung (U_{GS2}) des zweiten Feldeffekttransistors (7) ein erstes Abschaltniveau (U_{off1}) annimmt, zu einem zweiten Schaltzustand, in dem die Gate-Source-Spannung (U_{GS1}) des ersten Feldeffekttransistors (5) das erste Abschaltniveau (U_{off1}) annimmt und die Gate-Source-Spannung (U_{GS2}) des zweiten Feldeffekttransistors (7) das Einschaltniveau (Uₒₙ) annimmt, wobei
- zunächst die Gate-Source-Spannung (U_{GS1}) des ersten Feldeffekttransistors (5) von dem Einschaltniveau (Uₒₙ) auf ein zweites Abschaltniveau (U_{off2}), dessen Betrag größer als der Betrag des ersten Abschaltniveaus (U_{off1}) ist, geändert wird,
- dann die Gate-Source-Spannung (U_{GS2}) des zweiten Feldeffekttransistors (7) von dem ersten Abschaltniveau (U_{off1}) auf das Einschaltniveau (Uₒₙ) geändert wird
- und danach die Gate-Source-Spannung (U_{GS1}) des ersten Feldeffekttransistors (5) von dem zweiten Abschaltniveau (U_{off2}) auf das erste Abschaltniveau (U_{off1}) geändert wird,
**dadurch gekennzeichnet, dass**
einem Gate-Anschluss (G1) des ersten Feldeffekttransistors (5) eine Zusatzschaltung (17) mit einem ersten und einem zweiten zueinander parallel geschalteten Schaltungszweig vorgeschaltet wird,
wobei der erste Schaltungszweig einen Dämpfungswiderstand (25) und eine dazu in Reihe geschaltete Induktivität (27) aufweist und der zweite Schaltungszweig einen Vorwiderstand (23) und einen Hilfsschalter (29) aufweist und die Induktivität (27) und der Dämpfungswiderstand (25) bei einer Änderung einer Steuerspannung (U_{C1}) des ersten Feldeffekttransistors (5) von dem Einschaltniveau (Uₒₙ) auf das erste Abschaltniveau (U_{off1}) bei geöffnetem Hilfsschalter (29) eine vorübergehende Änderung der Gate-Source-Spannung (U_{GS1}) des ersten Feldeffekttransistors (5) auf das zweite Abschaltniveau (U_{off2}) bewirken,
- und zur Änderung der Gate-Source-Spannung (U_{GS1}) des ersten Feldeffekttransistors (5) von dem Einschaltniveau (Uₒₙ) auf das zweite Abschaltniveau (U_{off2}) die Steuerspannung (U_{C1}) des ersten Feldeffekttransistors (5) bei geöffnetem Hilfsschalter (29) von dem Einschaltniveau (Uₒₙ) auf das erste Abschaltniveau (U_{off1}) geändert wird.

2. Verfahren nach Anspruch 1, **dadurch gekennzeichnet, dass** eine Zeitdauer (T) vorgegeben wird, und dass die Gate-Source-Spannung (U_{GS2}) des zweiten Feldeffekttransistors (7) von dem ersten Abschaltniveau (U_{off1}) auf das Einschaltniveau (Uₒₙ) zu einem Zeitpunkt (t₂) geändert wird, der in einem durch die Zeitdauer (T) definierten zeitlichen Abstand auf das Ändern der Steuerspannung (U_{C1}) des ersten Feldeffekttransistors (5) von dem Einschaltniveau (Uₒₙ) auf das erste Abschaltniveau (U_{off1}) folgt.

3. Verfahren nach einem der vorhergehenden Ansprüche, **dadurch gekennzeichnet , dass** jeder Feldeffekttransistor (5, 7) als Grundmaterial einen Halbleiter mit breitem Bandabstand aufweist.

4. Verfahren nach Anspruch 3, **dadurch gekennzeichnet, dass** das Grundmaterial Siliziumkarbid ist.

5. Schaltanordnung (3) zum Ändern eines Schaltzustands einer Schalt-Halbbrücke (1), die einen ersten und einen zweiten Feldeffekttransistor (5, 7) aufweist, von einem ersten Schaltzustand, in dem eine Gate-Source-Spannung (U_{GS1}) des ersten Feldeffekttransistors (5) ein Einschaltniveau (Uₒₙ) annimmt und eine Gate-Source-Spannung (U_{GS2}) des zweiten Feldeffekttransistors (7) ein erstes Abschaltniveau (U_{off1}) annimmt, zu einem Schaltzustand, in dem die Gate-Source-Spannung (U_{GS1}) des ersten Feldeffekttransistors (5) das erste Abschaltniveau (U_{off1}) annimmt und die Gate-Source-Spannung (U_{GS2}) des zweiten Feldeffekttransistors (7) das Einschaltniveau (Uₒₙ) annimmt, die Schaltanordnung (3) aufweisend
- für jeden Feldeffekttransistor (5, 7) einen Gate-Treiber (15, 19) zum Ansteuern des Feldeffekttransistors (5, 7) mit einer Steuerspannung (U_{C1}, U_{C2}) ,
- und für jeden Feldeffekttransistor (5, 7) eine zwischen den Gate-Treiber (15, 19) und einen Gate-Anschluss (G1, G2) des Feldeffekttransistors (5, 7) schaltbare Zusatzschaltung (17, 21),
- wobei durch den Gate-Treiber (15, 19) und die Zusatzschaltung (17, 21) eine Gate-Source-Spannung (U_{GS1}, U_{GS2}) des Feldeffekttransistors (5, 7) auf das Einschaltniveau (Uₒₙ) , das erste Abschaltniveau (U_{off1}) und ein zweites Abschaltniveau (U_{off2}) , dessen Betrag größer als der Betrag des ersten Abschaltniveaus (U_{off1}) ist, einstellbar ist,
**dadurch gekennzeichnet, dass**
jede Zusatzschaltung (17, 21) einen ersten und einen zweiten zueinander parallel geschaltete Schaltungszweig aufweist, wobei der erste Schaltungszweig einen Dämpfungswiderstand (25) und eine dazu in Reihe geschaltete Induktivität (27) aufweist und der zweite Schaltungszweig einen Vorwiderstand (23) und einen Hilfsschalter (29) aufweist und die Induktivität (27) und der Dämpfungswiderstand (25) bei einer Änderung der Steuerspannung (U_{C1}, U_{C2}) von dem Einschaltniveau (Uₒₙ) auf das erste Abschaltniveau (U_{off1}) bei geöffnetem Hilfsschalter (29) eine vorübergehende Änderung der Gate-Source-Spannung (U_{GS1}, U_{GS2}) des jeweiligen Feldeffekttransistors (5, 7) auf das zweite Abschaltniveau (U_{off2}) bewirken.

6. Schaltanordnung (3) nach Anspruch 5, **dadurch gekennzeichnet , dass** jeder Feldeffekttransistor (5, 7) als Grundmaterial einen Halbleiter mit breitem Bandabstand aufweist.

7. Schaltanordnung (3) nach Anspruch 6, **dadurch gekennzeichnet, dass** das Grundmaterial Siliziumkarbid ist.

8. Stromrichter (100) mit wenigstens einer Schalt-Halbbrücke (1), die zwei Feldeffekttransistoren (5, 7) aufweist, und einer gemäß einem der Ansprüche 5 bis 7 ausgebildeten Schaltanordnung(3) zum Ändern eines Schaltzustands der Schalt-Halbbrücke (1).

## Claims

1. Method for changing a switching state of a switching half-bridge (1), which has a first and a second field-effect transistor (5, 7), from a first switching state, in which a gate-source voltage (U_{GS1}) of the first field-effect transistor (5) adopts a switch-on level (Uₒₙ) and a gate-source voltage (U_{Gs2}) of the second field-effect transistor (7) adopts a first switch-off level (U_{off1}), to a second switching state, in which the gate-source voltage (U_{GS1}) of the first field-effect transistor (5) adopts the first switch-off level (U_{off1}) and the gate-source voltage (U_{GS2}) of the second field-effect transistor (7) adopts the switch-on level (Uₒₙ), wherein
- the gate-source voltage (U_{GS1}) of the first field-effect transistor (5) is firstly changed from the switch-on level (Uₒₙ) to a second switch-off level (U_{off2}), the magnitude of which is greater than the magnitude of the first switch-off level (U_{off1}) ,
- then the gate-source voltage (U_{GS2}) of the second field-effect transistor (7) is changed from the first switch-off level (U_{off1}) to the switch-on level (Uₒₙ)
- and thereafter the gate-source voltage (U_{GS1}) of the first field-effect transistor (5) is changed from the second switch-off level (U_{off2}) to the first switch-off level (U_{off1}) ,
**characterised in that**
upstream of a gate terminal (G1) of the first field-effect transistor (5) is arranged a supplementary circuit (17) with a first and a second circuit branch connected parallel to one another, wherein the first circuit branch has a damping resistor (25) and an inductor (27) connected in series thereto and the second circuit branch has a series resistor (23) and an auxiliary switch (29) and, in the event of a change in a control voltage (U_{C1}) of the first field-effect transistor (5) from the switch-on level (Uₒₙ) to the first switch-off level (U_{off1}) with the auxiliary switch (29) open, the inductor (27) and the damping resistor (25) bring about a temporary change in the gate-source voltage (U_{GS1}) of the first field-effect transistor (5) to the second switch-off level (U_{off2}),
- and, in order to change the gate-source voltage (U_{GS1}) of the first field-effect transistor (5) from the switch-on level (Uₒₙ) to the second switch-off level (U_{off2}) , the control voltage (U_{C1}) of the first field-effect transistor (5) with the auxiliary switch (29) open is changed from the switch-on level (Uₒₙ) to the first switch-off level (U_{off1}) .

2. Method according to claim 1, **characterised in that** a duration (T) is predetermined and **in that** the gate-source voltage (U_{GS2}) of the second field-effect transistor (7) is changed from the first switch-off level (U_{off1}) to the switch-on level (Uₒₙ) at a point in time (t₂) which, in a time gap defined by the duration (T), follows the change in control voltage (U_{C1}) of the first field-effect transistor (5) from the switch-on level (Uₒₙ) to the first switch-off level (U_{off1}).

3. Method according to one of the preceding claims, **characterised in that** each field-effect transistor (5, 7) has a semiconductor with a wide bandgap as base material.

4. Method according to claim 3, **characterised in that** the base material is silicon carbide.

5. Switching arrangement (3) for changing a switching state of a switching half-bridge (1), which has a first and a second field-effect transistor (5, 7), from a first switching state, in which a gate-source voltage (U_{GS1}) of the first field-effect transistor (5) adopts a switch-on level (Uₒₙ) and a gate-source voltage (U_{GS2}) of the second field-effect transistor (7) adopts a first switch-off level (U_{off1}), to a switching state, in which the gate-source voltage (U_{GS1}) of the first field-effect transistor (5) adopts the first switch-off level (U_{off1}) and the gate-source voltage (U_{GS2}) of the second field-effect transistor (7) adopts the switch-on level (Uₒₙ), the switching arrangement (3) having
- for each field-effect transistor (5, 7) a gate driver (15, 19) for driving the field-effect transistor (5, 7) with a control voltage (U_{C1}, U_{C2}),
- and for each field-effect transistor (5, 7) a supplementary circuit (17, 21) switchable between the gate driver (15, 19) and a gate terminal (G1, G2) of the field-effect transistor (5, 7),
- wherein a gate-source voltage (U_{GS1}, U_{GS2}) of the field-effect transistor (5, 7) is adjustable by the gate driver (15, 19) and the supplementary circuit (17, 21) to the switch-on level (Uₒₙ), the first switch-off level (U_{off1}) and a second switch-off level (U_{off2}), the magnitude of which is greater than the magnitude of the first switch-off level (U_{off1}),
**characterised in that**
each supplementary circuit (17, 21) has a first and a second circuit branch connected parallel to one another, wherein the first circuit branch has a damping resistor (25) and an inductor (27) connected in series thereto and the second circuit branch has a series resistor (23) and an auxiliary switch (29) and, in the event of a change in the control voltage (U_{C1}, U_{C2}) from the switch-on level (Uₒₙ) to the first switch-off level (U_{off1}) with the auxiliary switch (29) open, the inductor (27) and the damping resistor (25) bring about a temporary change in the gate-source voltage (U_{GS1}, U_{GS2}) of the respective field-effect transistor (5, 7) to the second switch-off level (U_{off2}).

6. Switching arrangement (3) according to claim 5, **characterised in that** each field-effect transistor (5, 7) has a semiconductor with a wide bandgap as base material.

7. Switching arrangement (3) according to claim 6, **characterised in that** the base material is silicon carbide.

8. Power converter (100) with at least one switching half-bridge (1) which has two field-effect transistors (5, 7) and a switching arrangement (3) configured according to one of claims 5 to 7 for changing a switching state of the switching half-bridge (1).

## Revendications

1. Procédé de modification de l'état de commutation d'un demi pont (1) de commutation, qui a un premier et un deuxième transistor (5, 7) à effet de champ, d'un premier état de commutation, dans lequel une tension (U_{GS1}) de grille-source du premier transistor (5) à effet de champ prend un niveau (Uₒₙ) de passage et une tension (U_{GS2}) de grille-source du deuxième transistor (7) à effet de champ prend un premier niveau (U_{off1}) de blocage, à un deuxième état de commutation, dans lequel la tension (U_{GS1}) de grille-source du premier transistor (5) à effet de champ prend le premier niveau (U_{off1}) de blocage et la tension (U_{GS2}) de grille-source du deuxième transistor (7) à effet de champ prend le niveau (Uₒₙ) de passage, dans lequel
- on fait passer d'abord la tension (U_{GS1}) de grille-source du premier transistor (5) à effet de champ du niveau (Uₒₙ) de passage à un deuxième niveau (U_{off2}) de blocage, dont la valeur absolue est plus grande que la valeur absolue du premier niveau (U_{off1}) de blocage,
- on fait passer ensuite la tension (U_{GS2}) de grille-source du deuxième transistor (7) à effet de champ du premier niveau (U_{off1}) de blocage au niveau (Uₒₙ) de passage
- et ensuite, on fait passer la tension (U_{GS1}) de grille-source du premier transistor (5) à effet de champ du deuxième niveau (U_{off2}) de blocage au premier niveau (U_{off1}) de blocage,
**caractérisé en ce que**
l'on monte, en amont d'une borne (G1) de grille du premier transistor (5) à effet de champ, un circuit (17) supplémentaire ayant une première et une deuxième branches de circuit montées en parallèle entre elles,
dans lequel la première branche de commutation a une résistance (25) d'amortissement et une inductance (27) qui est montée en série avec elle et la deuxième branche de commutation a une résistance (23) série et un interrupteur (29) auxiliaire et l'inductance (27) et la résistance (25) d'amortissement provoquent, lorsqu'une tension (U_{c1}) de commande du premier transistor (5) à effet ce champ passe du niveau (Uₒₙ) de passage au premier niveau (U_{off1}) de blocage, alors que l'interrupteur (29) auxiliaire est ouvert, une variation transitoire de la tension (U_{GS1}) de grille-source du premier transistor (5) à effet de champ au deuxième niveau (U_{off2}) de blocage,
- et pour faire passer la tension (U_{GS1}) de grille-source du premier transistor (5) à effet de champ du niveau (Uₒₙ) de passage au deuxième niveau (U_{off2}) de blocage, on fait passer la tension (U_{c1}) de commande du premier transistor (5) à effet de champ, alors que l'interrupteur (29) auxiliaire est ouvert, du niveau (Uₒₙ) de passage au premier niveau (U_{off1}) de blocage.

2. Procédé suivant la revendication 1, **caractérisé en ce que** l'on prescrit une durée (T) et **en ce que** l'on fait passer la tension (U_{GS2}) de grille-source du deuxième transistor (7) à effet de champ du premier niveau (U_{off1}) de blocage au niveau (Uₒₙ) de passage à un instant (t₂), qui suit, dans un laps de temps défini par la durée ( T ), le passage de la tension (U_{c1}) de commande du premier transistor (5) à effet de champ du niveau (Uₒₙ) de passage au premier niveau (U_{off1}) de blocage.

3. Procédé suivant l'une des revendications précédentes, **caractérisé en ce que** chaque transistor (5, 7) à effet de champ a, comme matériau de base, un semi-conducteur à grand intervalle d'énergie entre deux bandes.

4. Procédé suivant la revendication 3, **caractérisé en ce que** le matériau de base est du carbure de silicium.

5. Montage (3) de commutation pour passer d'un état de commutation d'un demi pont (1) de commutation, qui a un premier et un deuxième transistor (5, 7) à effet de champ, d'un premier état de commutation, dans lequel une tension (U_{GS1}) de grille-source du premier transistor (5) à effet de champ prend un niveau (Uₒₙ) de passage et une tension (U_{GS2}) de grille-source du deuxième transistor (7) à effet de champ prend un premier niveau (U_{off1}) de blocage, à un deuxième état de commutation dans lequel la tension (U_{GS1}) de grille-source du premier transistor (5) à effet de champ prend le premier niveau (U_{off1}) de blocage et la tension (U_{GS2}) de grille-source du deuxième transistor (7) à effet de champ prend le niveau (Uₒₙ) de passage, le montage (3) de commutation comportant
- pour chaque transistor (5, 7) à effet de champ, un circuit d'attaque de grille (15, 19) pour commander le transistor (5, 7) à effet de champ par une tension (U_{c1}, U_{c2}) de commande,
- et pour chaque transistor (5, 7) à effet de champ, un circuit (17, 21) supplémentaire pouvant être monté entre le circuit d'attaque de grille (15, 19) et une borne (G1, G2) de grille du transistor (5, 7) à effet de champ,
- dans lequel par le circuit d'attaque de grille (15, 19) et par le circuit (17, 21) supplémentaire, une tension (U_{GS1}, U_{GS2}) de grille-source du transistor (5, 7) à effet de champ peut être réglée au niveau (Uₒₙ) de passage, au premier niveau (U_{off1}) de blocage et à un deuxième niveau (U_{off2}) de blocage, dont la valeur absolue est plus grande que la valeur absolue du premier niveau (U_{off1}) de blocage,
**caractérisé en ce que**
chaque circuit (17, 21) supplémentaire a une première et une deuxième branche de circuit montées en parallèle entre elles, la première branche de circuit ayant une résistance (25) d'amortissement et une inductance qui est montée en série avec elle et la deuxième branche de circuit ayant une résistance (23) série et un interrupteur (29) auxiliaire et l'inductance (27) et la résistance (25) d'amortissement provoquent, lorsque la tension (U_{c1}, U_{c2} ) de commande passe du niveau (Uₒₙ) de passage au premier niveau (U_{off1}) de blocage, alors que l'interrupteur (29) auxiliaire est ouvert, une variation temporaire de la tension (U_{GS1}, U_{GS2}) de grille-source du transistor (5, 7) à effet de champ respectif au deuxième niveau (U_{off2}) de blocage.

6. Montage (3) de commutation suivant la revendication 5, **caractérisé en ce que** chaque transistor (5, 7) à effet de champ a comme matériau de base un semi-conducteur à grand intervalle d'énergie entre deux bandes.

7. Montage (3) de commutation suivant la revendication 6, **caractérisé en ce que** le matériau de base est du carbure de silicium.

8. Convertisseur (100), comprenant au moins un demi pont (1) de commutation, qui a deux transistors (5, 7) à effet de champ et un montage (3) de commutation constitué suivant l'une des revendications 5 à 7 pour modifier un état de commutation du demi pont (1) de commutation.
